# EUROPEAN PATENT SPECIFICATION

(11) **EP 4 439 010 B1**
(45) Date of publication and mention of the grant of the patent: **25.02.2026**
(21) Application number: 24162903.9
(22) Date of filing: 12.03.2024
(51) Int. Cl.: G01C 19/5719, B81B 3/00, B81B 7/00, G01C 19/5733, G01C 19/5755, G01P 15/097

(54) **MICROELECTROMECHANICAL DEVICE WITH MOVABLE MASS AND STOPPER MECHANISM**
MIKROELEKTROMECHANISCHE VORRICHTUNG MIT BEWEGLICHER MASSE UND STOPPERMECHANISMUS
DISPOSITIF MICROELECTROMECANIQUE A MASSE MOBILE ET MECANISME D'ARRET

(30) Priority: 27.03.2023 IT 202300005814
(43) Date of publication of application: 02.10.2024
(73) Proprietor: STMicroelectronics International N.V., 1228 Plan-les-Ouates, Geneva (CH)
(72) Inventor: CARULLI, Paola, 20148 MILANO (IT); FEDELI, Patrick, 20030 SENAGO (MI) (IT); FALORNI, Luca Giuseppe, 20812 LIMBIATE (MB) (IT); MORELLI, Federico, 20146 MILANO (IT)
(74) Representative: Studio Torta S.p.A.

(56) References cited:
- EP-A1- 3 457 082
- WO-A1-2013/188131
- US-A1- 2017 082 519

## Description

### Technical field

The present invention relates to a micro-electro-mechanical (MEMS) device comprising a movable mass and a stopper mechanism.

### Background

Inertial micro-electro-mechanical (MEMS) devices, in particular for example gyroscopes and accelerometers, base their operation on masses coupled to a supporting body, such as for example a frame or a substrate of semiconductor material, through flexures (springs) which allow the masses to oscillate along one or more directions, in order to detect the variations of a physical quantity or to function as actuators.

In response to shocks that may occur during the life of the sensors (with acceleration values up to 10³ - 10⁵ g), the movable masses may exceed the range of work positions considered safe. To avoid damage, for example to the springs, stopper elements are provided which are capable of limiting the allowed displacement of the movable masses.

Typical stopper elements may comprise static blocks anchored to the substrate and arranged at a given distance from the masses (in the rest position), in the motion direction, so as to allow normal operation of the device and, at the same time, define a maximum displacement allowed to movable masses (i.e., a full stroke). Solutions of this type are for example disclosed in US 2017/082519 A1, WO 2013/188131 A1 and EP 3 457 082 A1.

The full stroke is in fact determined by a frontal impact between the movable mass and the stopper element; the latter typically has a suitably patterned surface so as to limit the stress generated at the interface between the two impacting surfaces.

The disadvantages of the known solution mainly reside in that the stop forces applied by the stopper elements may cause adhesion of the movable mass and/or damage to the structure. Furthermore, the movement direction of the movable mass after the impact against the stopper elements (rebound direction) may not be predictable since the direction of the shock forces, typically, is not perfectly collinear with the motion direction.

### Summary

It is therefore an aim of the present invention to overcome or at least mitigate the disadvantages and limitations of the state of the art.

According to the present invention, there is presented a MEMS device as defined in the appended claims.

### Brief Description of the Figures

For a better understanding of the present invention, preferred embodiments are presented, by way of non-limiting example, with reference to the attached drawings, wherein:
- Figure 1 illustrates, in top-plan view, a MEMS device according to an embodiment of the present invention, in a first operating configuration;
- Figure 2 illustrates, in top-plan view, a range of admissible positions of a component of the MEMS device of Figure 1;
- Figure 3 illustrates, in top-plan view, the MEMS device of Figure 1 in a second operating configuration;
- Figure 4 illustrates, in top-plan view, an enlarged detail of the MEMS device of Figure 1;
- Figure 5 illustrates, in top-plan view, a MEMS device according to another embodiment of the present invention;
- Figure 6 illustrates, in top-plan view, a MEMS device according to a further embodiment of the present invention; and
- Figure 7 illustrates, in top-plan view, a range of admissible positions of a component of the MEMS device of Figure 6.

### Description of Embodiments

The following description refers to the arrangement shown in the drawings; accordingly, expressions such as "above", "below", "upper", "lower", "top", "bottom", "right", "left" and the like relate to the accompanying figures and are not to be interpreted in a limiting manner.

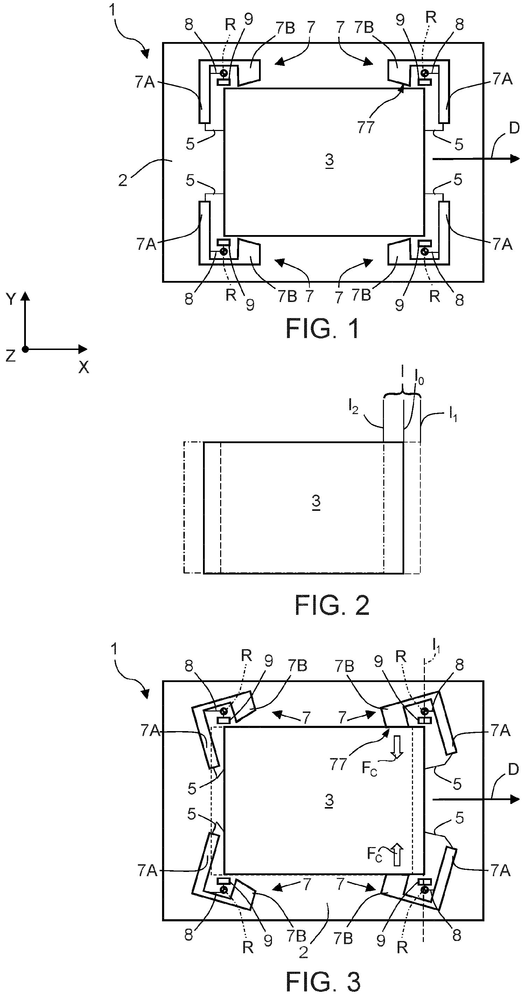

Figures 1-3 illustrate a microelectromechanical or MEMS device 1 according to an embodiment of the present invention, for example, an inertial sensor, such as an accelerometer or a gyroscope. The MEMS device 1 comprises a supporting body 2, for example a substrate of semiconductor material, and a movable mass 3 coupled to the supporting body 2 so as to be able to oscillate along one or more motion directions within a range I of admissible positions (Figure 2), as described in more detail hereinbelow. Each range I is delimited by opposite endpoints I₁, I₂, corresponding to full-stroke positions of the movable mass 3, and includes a rest position I₀, not necessarily central.

In Figure 1, the MEMS device 1 is for example shown in its rest condition (I₀ in Figure 2), i.e. when the movable mass 3 is stationary, in the absence of external forces applied. In one embodiment, the movement of the movable mass 3 is allowed along a motion direction D, for example a detection or drive direction parallel to a horizontal axis X of a triaxial reference system of axes X, Y, Z orthogonal to each other.

The MEMS device 1 also comprises stopper elements 7, arranged around the movable mass 3 and coupled to the supporting body 2 through anchors 9. In particular, the stopper elements 7 are supported by respective anchors 9 by means of connection elements 8 configured to allow the rotation of the stopper elements 7 around respective rotation axes R parallel to the vertical axis Z.

The movable mass 3 is connected, through coupling elements 5, to the stopper elements 7.

The coupling elements 5 comprise flexures (springs) which constrain the movable mass 3 to the stopper elements 7 and, together with the anchors 9 and the connection elements 8, keep the movable mass 3 suspended, in the direction of the vertical axis Z, with respect to the supporting body 2.

The stopper elements 7 are configured to limit the movement of the movable mass 3 along the motion direction D within the range I of admissible positions. In the MEMS device 1, the stopper elements 7 have a generic "L"-shape and are provided with transmission arms 7A and stopper arms 7B.

The stopper elements 7 are operated by the movable mass 3 through the coupling elements 5 which, in the MEMS device 1, connect the movable mass 3 to the ends of the transmission arms 7A of the stopper elements 7 opposite to the anchors 9.

During the movement of the movable mass 3 along the motion direction D allowed, the movable mass 3 operates the stopper elements 7 through the coupling elements 5.

In particular, the movable mass 3 pushes/pulls the transmission arms 7A thus causing the rotation of the stopper elements 7 around the respective rotation axes R.

The stopper elements 7, and in particular the stopper arms 7B, are sized so as to ensure suitable stiffness and allow normal operation of the MEMS device 1, as long as the movement of the movable mass 3 is contained within the range I of admissible positions from the rest position I₀ designed.

Figure 3 instead shows a full-stroke condition of the movement of the movable mass 3, in particular for a movement to the right in the motion direction D, for example in response to a shock.

When the movable mass 3 reaches one of the endpoints I₁, I₂ of the range I of admissible positions (the endpoint I₁ in Figure 3), the stopper elements 7 on the side of the movable mass 3 moving towards rotate to the point that the respective stopper arms 7B come into contact with the movable mass 3 and clamp it.

More precisely, ends 77 of the stopper arms 7B, due to the rotation, apply stop forces F_{C} to opposite sides of the movable mass 3 transversely to the motion direction D, thereby creating a "clamping effect".

In the example of Figure 3, the stop forces F_{C} are perpendicular to the motion direction D and to the axis Z.

For clarity of understanding, Figure 3 also shows the position of the movable mass 3 at rest.

The stopper elements 7 on the side of the movable mass 3 moving away are dragged by the movement of the movable mass 3 and rotate so that the respective stopper arms 7B tend to open, without interfering in the stop action.

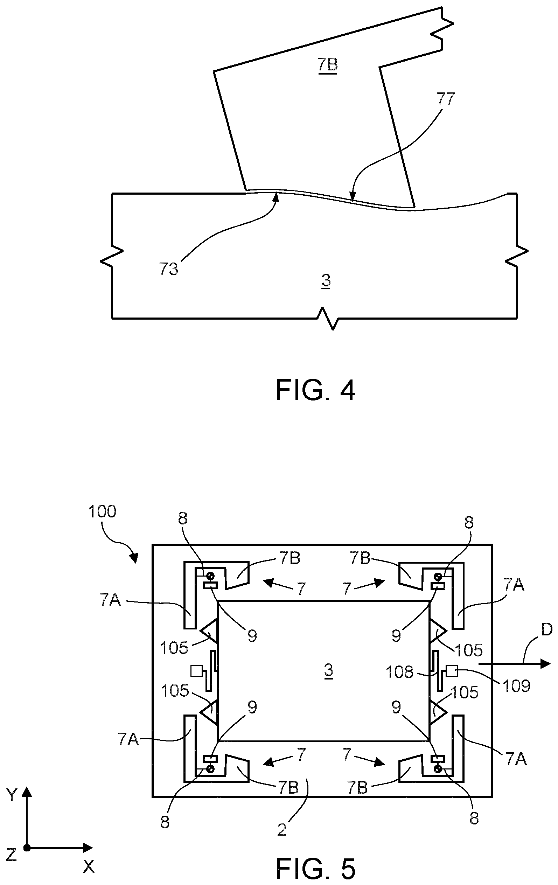

With reference to Figure 4, the ends 77 of the stopper arms 7B are patterned so as to engage respective seats 73 on sides of the movable mass 3 when the corresponding endpoint I₁, I₂ of the range I is reached, thereby allowing control of the direction of stop forces F_{C} applied.

In Figure 3, for example, the ends 77 of the stopper arms 7B are shaped so as to come into contact in a parallel manner to the side of the movable mass 3.

When the action of the stopper elements 7 following a shock undergone by the movable mass 3 exprires, the system made by the movable mass 3, the coupling elements 5 and the stopper elements 7 returns to normal operation.

The intensity of the stop forces F_{C} may be selected according to the design preferences by acting on the ratio between the lengths of the stopper arms 7B and the transmission arms 7A.

The Applicant has verified that the stop forces F_{C} applied by the stopper arms 7B may be lower than those obtained by employing static-block stopper elements which frontally stop the movable mass 3. The stop forces F_{C} are also a balanced force system on the structure of the MEMS device 1.

The "clamping effect" that is created also limits the movement of the movable mass 3 also in the direction perpendicular to the direction preset for the movement (in Figure 1, 3 according to the axis Y), ensuring greater stiffness to the transverse movement.

The overall benefits obtained include a lower risk of damage of the entire structure and a more controlled and predictable rebound direction of the movable mass 3.

Figure 5 shows a MEMS device 100 according to a different embodiment of the invention. Elements of Figure 5 which correspond to elements of Figure 1 are illustrated with the same reference numerals, in particular, the supporting body 2, the movable mass 3, the stopper elements 7 and the anchors 9.

Coupling elements 105 may comprise protrusions of a rigid material, which extend from the movable mass 3 towards respective stopper elements 7. The coupling elements 105 come into contact with the transmission arms 7A of the respective stopper elements 7 on the side moving towards due to the oscillations of the movable mass 3 and cause the rotation of the respective stopper elements 7. On the side moving away, the coupling elements 105 may separate from respective stopper elements 7. In this case, the connection elements 8 exert elastic return forces which take the stopper elements 7 towards rest configurations, wherein the stopper arms 7B are separated from the movable mass 3 and do not interfere with the oscillation.

The stopper elements 7 therefore act as previously described, clamping the movable mass 3 simultaneously on opposite sides.

In the embodiment of Figure 5, the movable mass 3 is kept suspended with respect to the supporting body 2 by means of further connection elements 108 and anchors 109. In particular, the connection elements 108 are shaped so as to allow the movement of the movable mass 3 according to the motion direction D.

In Figure 5 the movable mass 3 is in rest condition.

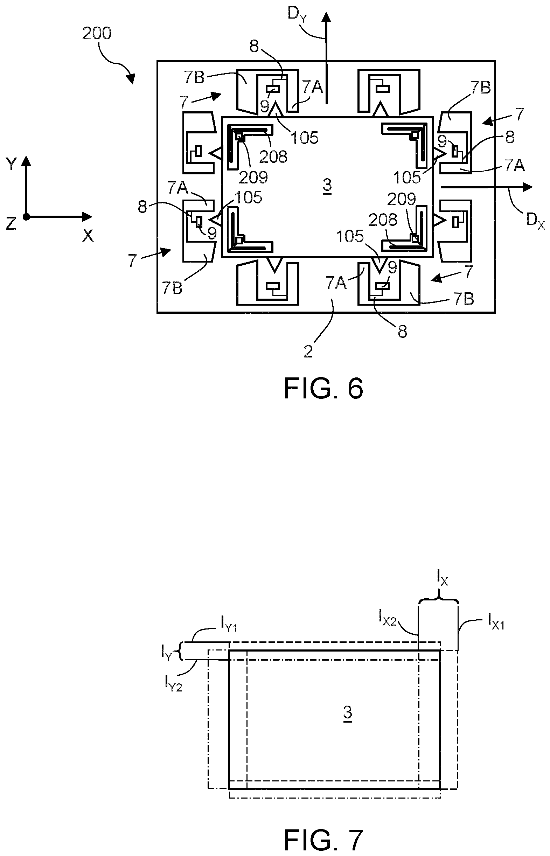

Figure 6 shows a MEMS device 200 according to another embodiment of the invention. Elements of Figure 6 which correspond to elements of Figures 1, 5 are illustrated with the same reference numerals.

In the MEMS device 200, the movable mass 3 is movable with a first degree of freedom along a first motion direction D_{X}, within a first range I_{X} of admissible positions, defined by a respective first endpoint I_{X1} and a respective second endpoint I_{X2}; and with a second degree of freedom along a second motion direction D_{Y}, perpendicular to the first motion direction D_{X} and to the axis Z, within a second range I_{Y} of admissible positions, defined by a respective first endpoint I_{Y1} and a respective second endpoint I_{Y2}. The endpoints I_{X1}, I_{X2} and the endpoints I_{Y1}, I_{Y2} may be different (Figure 7).

The MEMS device 200 comprises stopper elements 7 oriented in such a way as to implement, in an independent manner, the "clamping effect" previously described for movements of the movable mass 3 which exceed both the range I_{X} of admissible positions along the first motion direction D_{X}, and the range I_{Y} of admissible positions along the second motion direction D_{Y}.

In this embodiment, the coupling elements 105 comprise protrusions of a rigid material, for example having the shape of a triangular-based prism, which extend from the movable mass 3 towards respective stopper elements 7. The stopper elements 7 are sized in such a way as not to interfere during normal operation of the MEMS device 200 and in such a way that the stop actions exerted along the motion directions D_{X}, D_{Y}, perpendicular to each other, do not interfere with one another.

The coupling elements 105 come into contact with the transmission arms 7A of the respective stopper elements 7 close to the coupling elements 105 (considered, by analogy to what has been previously described, moving towards), operating the rotation of the respective stopper elements 7 around the respective rotation axes R. The coupling elements 105 moving away may instead separate from the respective and close stopper elements 7.

For movements of the movable mass 3 which exceed the ranges I_{X}, I_{Y} of admissible positions, the stopper elements 7 therefore act as previously described, clamping the movable mass 3 simultaneously on opposite sides.

In Figure 6, each stopper element 7 has the transmission arm 7A and the stopper arm 7B facing a same side of the movable mass 3. The stopper elements 7 which clamp the movable mass 3 for movements that exceed the range I_{X} of admissible positions along the motion direction D_{X} face first sides of the movable mass 3; the stopper elements 7 which clamp the movable mass 3 for movements that exceed the range I_{Y} of admissible positions along the motion direction D_{Y} face second sides of the movable mass 3 orthogonal to the first sides.

In the embodiment of Figure 6, the movable mass 3 is kept suspended with respect to the supporting body 2 by means of further connection elements 208 and anchors 209. In particular, the connection elements 208 are shaped so as to allow the movement of the movable mass 3 according to the motion directions D_{X}, D_{Y}.

In Figure 6 the movable mass 3 is in rest condition.

Finally, it is clear that modifications and variations may be made to what has been described and illustrated herein without thereby departing from the scope of the present invention, as defined in the attached claims.

## Claims

1. A microelectromechanical device (1; 100; 200) comprising:
a supporting body (2), containing semiconductor material; and
a movable mass (3), constrained to the supporting body with a relative degree of freedom with respect to at least one motion direction (D; D_{X}; D_{Y}), within a range (I; I_{X}; Iy) of admissible positions,
**characterized by** further comprising:
stopper elements (7), operable by the movable mass (3) due to movements along the at least one motion direction and configured to apply stop forces (F_{C}) to opposite sides of the movable mass (3) transversely to the at least one motion direction when the movable mass (3) reaches a respective endpoint (I₁, I₂; I_{X1}, I_{X2}; I_{Y1}, I_{Y2}) of the range of admissible positions, so as to prevent the movable mass (3) from exceeding the respective endpoint; and
anchors (9), fixed to the supporting body (2), wherein the stopper elements (7) are coupled to respective anchors (9) in a rotatable manner around respective rotation axes (R) perpendicular to the at least one motion direction (D; D_{X}; D_{Y}), and
wherein the stopper elements (7) are rotated by the movable mass (3) and are configured to clamp the movable mass (3) due to the rotation.

2. The device (1; 100; 200) according to claim 1, further comprising connection elements (8) connecting the stopper elements (7) to the respective anchors (9) and configured to allow rotations of the stopper elements (7) around the respective rotation axes (R).

3. The device (1; 100; 200) according to claim 2, wherein the stopper elements (7) are arranged around the movable mass (3) and are coupled to the movable mass (3) so that the stopper elements (7) cooperating to clamp the movable mass (3) rotate in respective opposite directions in response to movements of the movable mass (3) along the at least one motion direction (D; D_{X}; D_{Y}).

4. The device (1; 100; 200) according to any of the preceding claims, comprising coupling elements (5; 105), constrained to the movable mass (3) and configured to operate the stopper elements (7) due to movements of the movable mass (3) along the at least one motion direction.

5. The device (1) according to claim 4 when dependent on claim 2, wherein the coupling elements (5) are fixed to the movable mass (3) and to the stopper elements (7) and wherein the anchors (9), the connection elements (8) and the coupling elements (5) are configured to keep the movable mass suspended with respect to the supporting body (2).

6. The device (100; 200) according to any of claims 1 to 4, comprising further connection elements (108; 208) and further anchors (109; 209), wherein the movable mass (3) is kept suspended with respect to the supporting body (2) by the further connection elements (108; 208) and by the further anchors (109; 209), the further connection elements (108; 208) being shaped so as to allow the movement of the movable mass according to the at least one motion direction (D; D_{X}; D_{Y}) of the movable mass (3).

7. The device (1) according to any of claims 4 to 6, wherein the coupling elements (5) comprise flexures.

8. The device (100; 200) according to any of claims 4 to 7, wherein the coupling elements (105) comprise protrusions of a rigid material carried by the movable mass (3).

9. The device (1; 100; 200) according to any of claims 4 to 8, wherein the stopper elements (7) comprise respective transmission arms (7A) coupled to the movable mass (3), by means of the respective coupling elements (5; 105), so as to cause the rotation of the stopper elements (7) around the respective rotation axes (R) in response to movements of the movable mass (3) along the at least one motion direction (D; D_{X}; D_{Y}).

10. The device (1; 100; 200) according to any of claims 4 to 9, wherein the stopper elements (7) comprise stopper arms (7B) having ends (77) configured to clamp the movable mass (3) when the movable mass (3) reaches the respective endpoint of the range of admissible positions.

11. The device (1; 100; 200) according to the preceding claim, wherein the ends (77) of the stopper arms (7B) are patterned so as to engage respective seats (73) on sides of the movable mass (3) when the movable mass reaches the respective endpoint of the range of admissible positions.

12. The device (1; 100) according to claim 10 or 11, wherein in each stopper element (7) the transmission arm (7A) and the stopper arm (7B) face respective orthogonal sides of the movable mass (3).

13. The device (200) according to claim 10 or 11, wherein each stopper element (7) has the transmission arm (7A) and the stopper arm (7B) facing a same side of the movable mass (3).

## Patentansprüche

1. Mikroelektromechanische Vorrichtung (1; 100; 200), umfassend:
einen Stützkörper (2), der Halbleitermaterial enthält; und
eine bewegliche Masse (3), die mit einem relativen Freiheitsgrad in Bezug auf mindestens eine Bewegungsrichtung (D; D_{X}; D_{Y}) innerhalb eines Bereichs (I; I_{X}; I_{Y}) zulässiger Positionen auf den Stützkörper beschränkt ist,
**dadurch gekennzeichnet, dass** sie weiter umfasst:
Stopperelemente (7), die durch die bewegliche Masse (3) aufgrund von Bewegungen entlang der mindestens einen Bewegungsrichtung betätigt werden können und dazu ausgelegt sind, Stoppkräfte (F_{C}) an gegenüberliegende Seiten der beweglichen Masse (3) quer zu der mindestens einen Bewegungsrichtung anzulegen, wenn die bewegliche Masse (3) einen jeweiligen Endpunkt (I₁, I₂; I_{X1}, I_{X2}; I_{Y1}, I_{Y2}) des Bereichs zulässiger Positionen erreicht, um zu verhindern, dass die bewegliche Masse (3) den jeweiligen Endpunkt überschreitet; und
Anker (9), die an dem Stützkörper (2) befestigt sind, wobei die Stopperelemente (7) um jeweilige Drehachsen (R), die senkrecht zu der mindestens einen Bewegungsrichtung (D; D_{X}; D_{Y}) stehen, drehbar mit jeweiligen Ankern (9) gekoppelt sind, und
wobei die Stopperelemente (7) von der beweglichen Masse (3) gedreht werden und dazu ausgelegt sind, die bewegliche Masse (3) aufgrund der Drehung zu verklemmen.

2. Vorrichtung (1; 100; 200) nach Anspruch 1, die weiter Verbindungselemente (8) umfasst, die die Stopperelemente (7) mit den jeweiligen Ankern (9) verbinden und dazu ausgelegt sind, Drehungen der Stopperelemente (7) um die jeweiligen Drehsachsen (R) zu ermöglichen.

3. Vorrichtung (1; 100; 200) nach Anspruch 2, wobei die Stopperelemente (7) um die bewegliche Masse (3) angeordnet sind und mit der beweglichen Masse (3) so gekoppelt sind, dass die Stopperelemente (7), die zusammenwirken, um die bewegliche Masse (3) zu verklemmen, in Reaktion auf Bewegungen der beweglichen Masse (3) entlang der mindestens einen Bewegungsrichtung (D; D_{X}; D_{Y}) in jeweilige entgegengesetzte Richtungen drehen.

4. Vorrichtung (1; 100; 200) nach einem der vorstehenden Ansprüche, die Koppelelemente (5; 105) umfasst, die auf die bewegliche Masse (3) beschränkt und dazu ausgelegt sind, die Stopperelemente (7) aufgrund von Bewegungen der beweglichen Masse (3) entlang der mindestens einen Bewegungsrichtung zu betätigen.

5. Vorrichtung (1) nach Anspruch 4 in Abhängigkeit von Anspruch 2, wobei die Koppelelemente (5) an der beweglichen Masse (3) und an den Stopperelementen (7) befestigt sind und wobei die Anker (9), die Verbindungselemente (8) und die Koppelelemente (5) dazu ausgelegt sind, die bewegliche Masse in Bezug auf den Stützkörper (2) aufgehängt zu halten.

6. Vorrichtung (100; 200) nach einem der Ansprüche 1 bis 4, die weitere Verbindungselemente (108; 208) und weitere Anker (109; 209) umfasst, wobei die bewegliche Masse (3) durch die weiteren Verbindungselemente (108; 208) und die weiteren Anker (109; 209) in Bezug auf den Stützkörper (2) aufgehängt gehalten wird, wobei die weiteren Verbindungselemente (108; 208) so geformt sind, dass sie die Bewegung der beweglichen Masse gemäß der mindestens einen Bewegungsrichtung (D; D_{X}; D_{Y}) der beweglichen Masse (3) ermöglichen.

7. Vorrichtung (1) nach einem der Ansprüche 4 bis 6, wobei die Koppelelemente (5) Biegungen umfassen.

8. Vorrichtung (100; 200) nach einem der Ansprüche 4 bis 7, wobei die Koppelelemente (105) Vorsprünge aus einem starren Material umfassen, die von der beweglichen Masse (3) getragen werden.

9. Vorrichtung (1; 100; 200) nach einem der Ansprüche 4 bis 8, wobei die Stopperelemente (7) jeweilige Übertragungsarme (7A) umfassen, die mittels der jeweiligen Koppelelemente (5; 105) mit der beweglichen Masse (3) gekoppelt sind, um in Reaktion auf Bewegungen der beweglichen Masse (3) entlang der mindestens einen Bewegungsrichtung (D; D_{X}; D_{Y}) die Drehung der Stopperelemente (7) um die jeweiligen Drehachsen (R) zu bewirken.

10. Vorrichtung (1; 100; 200) nach einem der Ansprüche 4 bis 9, wobei die Stopperelemente (7) Stopperarme (7B) umfassen, die Enden (77) aufweisen, die dazu ausgelegt sind die bewegliche Masse (3) zu verklemmen, wenn die bewegliche Masse (3) den jeweiligen Endpunkt des Bereichs zulässiger Positionen erreicht.

11. Vorrichtung (1; 100; 200) nach dem vorstehenden Anspruch, wobei die Enden (77) der Stopperarme (7B) strukturiert sind, um jeweilige Sitze (73) an Seiten der beweglichen Masse (3) in Eingriff zu nehmen, wenn die bewegliche Masse den jeweiligen Endpunkt des Bereichs zulässiger Positionen erreicht.

12. Vorrichtung (1; 100) nach Anspruch 10 oder 11, wobei in jedem Stopperelement (7) der Übertragungsarm (7A) und der Stopperarm (7B) jeweiligen orthogonalen Seiten der beweglichen Masse (3) zugewandt sind.

13. Vorrichtung (200) nach Anspruch 10 oder 11, wobei jedes Stopperelement (7) den Übertragungsarm (7A) und den Stopperarm (7B) derselben Seite der beweglichen Masse (3) zugewandt aufweist.

## Revendications

1. Dispositif microélectromécanique (1 ; 100 ; 200) comprenant :
un corps de support (2) contenant un matériau semiconducteur ; et
une masse mobile (3), fixée sur le corps de support avec un degré de liberté relatif par rapport à au moins une direction de déplacement (D ; D_{X} ; Dy), dans les limites d'une plage (I ; I_{X} ; I_{Y}) de positions admissibles,
**caractérisé en ce qu'**il comprend en outre :
des éléments d'arrêt (7), pouvant être actionnés par la masse mobile (3) suite aux mouvements le long de ladite au moins une direction de déplacement et configurés pour appliquer des forces d'arrêt (F_{C}) à des côtés opposés de la masse mobile (3) de manière transversale par rapport à ladite au moins une direction de déplacement quand la masse mobile (3) atteint un point limite respectif (I₁, I₂ ; I_{X1}, I_{X2} ; I_{Y1}, I_{Y2}) de la plage de positions admissibles, afin d'empêcher la masse mobile (3) de dépasser le point limite respectif ; et
des ancrages (9), fixés au corps de support (2), les éléments d'arrêt (7) étant accouplés à des ancrages respectifs (9) de manière rotative autour d'axes de rotation respectifs (R) perpendiculaires à ladite au moins une direction de déplacement (D ; D_{X} ; Dy), et
dans lequel les éléments d'arrêt (7) sont mis en rotation par la masse mobile (3) et sont configurés pour immobiliser la masse mobile (3) suite à la rotation.

2. Dispositif (1 ; 100 ; 200) selon la revendication 1, comprenant en outre des éléments de connexion (8) reliant les éléments d'arrêt (7) aux ancrages respectifs (9) et configurés pour permettre des rotations des éléments d'arrêt (7) autour des axes de rotation respectifs (R).

3. Dispositif (1 ; 100 ; 200) selon la revendication 2, dans lequel les éléments d'arrêt (7) sont disposés autour de la masse mobile (3) et sont accouplés à la masse mobile (3) de telle manière que les éléments d'arrêt (7) coopérant pour immobiliser la masse mobile (3) tournent dans des directions respectives opposées en réponse aux mouvements de la masse mobile (3) le long de ladite au moins une direction de déplacement (D ; D_{X} ; D_{Y}).

4. Dispositif (1 ; 100 ; 200) selon l'une quelconque des revendications précédentes, comprenant des éléments d'accouplement (5 ; 105) solidaires de la masse mobile (3) et configurés pour actionner les éléments d'arrêt (7) suite aux mouvements de la masse mobile (3) le long de ladite au moins une direction de déplacement.

5. Dispositif (1) selon la revendication 4 lorsqu'elle dépend de la revendication 2, dans lequel les éléments d'accouplement (5) sont fixés sur la masse mobile (3) et sur les éléments d'arrêt (7) et dans lequel les ancrages (9), les éléments de connexion (8) et les éléments d'accouplement (5) sont configurés pour maintenir la masse mobile suspendue par rapport au corps de support (2).

6. Dispositif (100 ; 200) selon l'une quelconque des revendications 1 à 4, comprenant des éléments de connexion supplémentaires (108 ; 208) et des ancrages supplémentaires (109 ; 209), dans lequel la masse mobile (3) est maintenue suspendue par rapport au corps de support (2) par les éléments de connexion supplémentaires (108 ; 208) et par les ancrages supplémentaires (109 ; 209), les éléments de connexion supplémentaires (108 ; 208) ayant une forme conçue pour permettre le mouvement de la masse mobile selon ladite au moins une direction de déplacement (D ; D_{X} ; D_{Y}) de la masse mobile (3).

7. Dispositif (1) selon l'une quelconque des revendications 4 à 6, dans lequel les éléments d'accouplement (5) comprennent des joints flexibles.

8. Dispositif (100 ; 200) selon l'une quelconque des revendications 4 à 7, dans lequel les éléments d'accouplement (5) comprennent des protubérances faites d'un matériau rigide, portées par la masse mobile (3).

9. Dispositif (1 ; 100 ; 200) selon l'une quelconque des revendications 4 à 8, dans lequel les éléments d'arrêt (7) comprennent des bras de transmission respectifs (7A) accouplés à la masse mobile (3), au moyen des éléments d'accouplement respectifs (5 ; 105), afin de provoquer la rotation des éléments d'arrêt (7) autour des axes de rotation respectifs (R) en réponse aux mouvements de la masse mobile (3) le long de ladite au moins une direction de déplacement (D ; D_{X} ; D_{Y}).

10. Dispositif (1 ; 100 ; 200) selon l'une quelconque des revendications 4 à 9, dans lequel les éléments d'arrêt (7) comprennent des bras d'arrêt (7B) ayant des extrémités (77) configurées pour immobiliser la masse mobile (3) quand la masse mobile (3) atteint le point limite respectif de la plage de positions admissibles.

11. Dispositif (1 ; 100 ; 200) selon la revendication précédente, dans lequel les extrémités (77) des bras d'arrêt (7B) forment un motif de manière à se mettre en prise avec des sièges respectifs (73) sur des côtés de la masse mobile (3) quand la masse mobile atteint le point limite respectif de la plage de positions admissibles.

12. Dispositif (1 ; 100) selon la revendication 10 ou 11, dans lequel, dans chaque élément d'arrêt (7), le bras de transmission (7A) et le bras d'arrêt (7B) se trouvent en face de côtés orthogonaux respectifs de la masse mobile (3).

13. Dispositif (200) selon la revendication 10 ou 11, dans lequel, dans chaque élément d'arrêt (7), le bras de transmission (7A) et le bras d'arrêt (7B) se trouvent en face d'un même côté de la masse mobile (3).
